# EUROPEAN PATENT APPLICATION

(11) **EP 2 355 342 A2**
(43) Date of publication of application: **10.08.2011**
(21) Application number: 11153440.0
(22) Date of filing: 04.02.2011
(51) Int. Cl.: H03H 9/10, H03H 9/05, H03H 9/17

(54) **Piezoelectric vibrator and oscillator using the same**

(30) Priority: 05.02.2010 JP 2010024658
(71) Applicant: Seiko Instruments Inc., Chiba-shi, Chiba (JP)
(72) Inventor: Tange, Yoshihisa, Chiba-shi, Chiba (JP)
(74) Representative: Cloughley, Peter Andrew

(57) **Abstract**

In a piezoelectric vibrator in which a piezoelectric vibrating reed is mounted on a mounting portion installed on a surface of the base substrate in a cantilevered state and the piezoelectric vibrating reed is accommodated to be covered by a lid substrate, the resistance of a lead-out electrode for supplying a drive power to the piezoelectric vibrating reed is reduced, thereby preventing degradation of vibrating performance. A first lead-out electrode formed between a mounting portion of a base substrate and a first through-electrode is formed in a peripheral region so as not to overlap with first and second excitation electrodes formed on outer surfaces of a piezoelectric vibrating reed for driving, thereby reducing the resistance of the first lead-out electrode.

## Description

The present invention relates to a piezoelectric vibrator which encloses a piezoelectric vibrating reed in a cavity formed between substrates and an oscillator using the same, and more particularly, to a small-sized piezoelectric vibrator.

In recent years, piezoelectric vibrators using crystals or the like have been used as time sources or timing sources for portable phones or portable information terminal devices. Various types of piezoelectric vibrators are known, and as an example, a surface-mounted piezoelectric vibrator is known. As the surface-mounted piezoelectric vibrator, there is one known having a three-layer structure type in which a piezoelectric substrate provided with a piezoelectric vibrating reed is interposed between a base substrate and a lid substrate in the vertical direction. The piezoelectric vibrating reed is accommodated in a cavity formed between the base substrate and the lid substrate. Recently, a piezoelectric vibrator with a two-layer structure type has been developed. In this type, a cavity is formed of a concave portion provided on an inner surface of the base substrate or the lid substrate, a piezoelectric vibrating reed is mounted on a surface of the base substrate, and the lid substrate is directly bonded to a periphery of the base substrate to accommodate the piezoelectric vibrating reed in the corresponding cavity. The piezoelectric vibrator with the two-layer structure type is excellent because it can achieve a reduction in thickness compared to the three-layer structure type (for example, refer to JP-A-2009-232449).

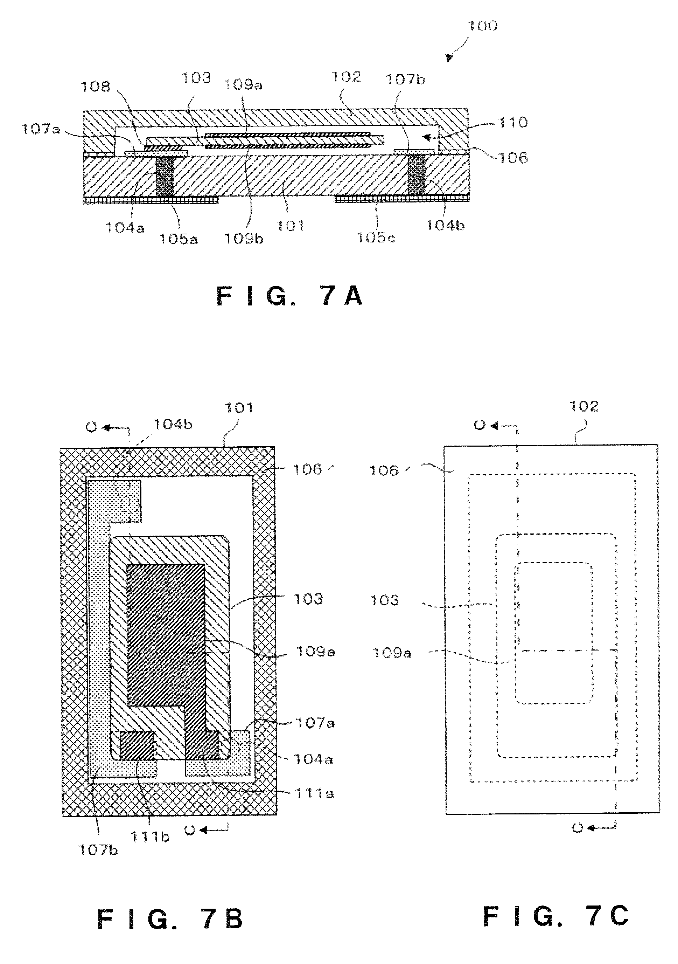

Figs. 7A to 7C are explanatory views of a piezoelectric vibrator 100 having a two-layer structure type. Fig. 7A is a cross-sectional view schematically illustrating the piezoelectric vibrator 100, Fig. 7B is a top view schematically illustrating a base substrate 101 which is a lower substrate, and Fig. 7C is a top view schematically illustrating a lid substrate 102 which is an upper substrate. Moreover, Fig. 7A illustrates a cross-section taken along the line C-C of the top views of Figs. 7B and 7C.

As illustrated in Fig. 7A, the piezoelectric vibrator 100 includes the base substrate 101, the lid substrate 102 bonded to an upper surface of an outer periphery of the base substrate 101 via a bonding material 106, and a piezoelectric vibrating reed 103 mounted on the upper surface of the base substrate 101 in a cantilevered state. The surface of the lid substrate 102 on the base substrate 101 side is provided with a cavity 110 as a concave portion so as to accommodate the piezoelectric vibrating reed 103.

A crystal plate is used for the piezoelectric vibrating reed 103. Through-electrodes 104a and 104b are implanted in the base substrate 101, and outer electrodes 105a and 105c and lead-out electrodes 107a and 107b are respectively connected to an outer surface and an inner surface of the base substrate 101. The piezoelectric vibrating reed 103 is mounted on the lead-out electrodes 107a and 107b.

As illustrated in Fig. 7B, the two through-electrodes 104a and 104b are provided in substantially diagonal portions, the lead-out electrode 107b is formed from a corner portion of an upper side to a corner portion of a lower side, and the lead-out electrode 107a is formed on an upper surface of the through-electrode 104a and on the base substrate 101 in the vicinity thereof. In addition, a mounting member 108 is formed on upper surfaces of the lead-out electrodes 107a and 107b, and the piezoelectric vibrating reed 103 is held thereon in the cantilevered state.

Excitation electrodes 109a and 109b are provided on both surfaces of the piezoelectric vibrating reed 103 to be opposite to each other, are electrically connected to terminal electrodes 111a and 111b provided under end portions of a lower side of the piezoelectric vibrating reed 103, and are respectively connected to the lead-out electrodes 107a and 107b via the mounting member 108. Therefore, the outer electrode 105a is electrically connected to the excitation electrode 109a via the through-electrode 104a, the lead-out electrode 107a, the mounting member 108, and the terminal electrode 111a. In addition, the outer electrode 105c is electrically connected to the excitation electrode 109b via the through-electrode 104b, the lead-out electrode 107b, the mounting member 108, and the terminal electrode 111b. That is, drive power is applied to the excitation electrodes 109a and 109b from the outer electrodes 105a and 105c to excite the piezoelectric vibrating reed 103, thereby generating a signal having a predetermined period.

In recent years, reduction in the sizes of portable devices and portable terminals has been progressing. With this, a reduction in the size of the piezoelectric vibrator 100 is also required. When the size of the piezoelectric vibrator 100 is reduced, the sizes of the piezoelectric vibrating reed 103 and the lead-out electrode 107 and areas of the bonding material 106 need to be reduced. However, for example, in a case where the crystal plate is used for the piezoelectric vibrating reed 103, if the size of the piezoelectric vibrating reed 103 is reduced, the CI value (crystal impedance value) is increased, and thus vibration characteristics are deteriorated. In addition, in order to stabilize vibrations of the piezoelectric vibrating reed 103, the inside of the cavity 110 has to be blocked from the air. For example, the cavity 110 is maintained in a vacuum state. Accordingly, the bonding material 106 needs to have a certain degree of width.

In addition, when a parasitic capacitance occurs between the lead-out electrode 107b and the excitation electrode 109, the vibration characteristics are deteriorated. Accordingly, the lead-out electrodes 107b and the excitation electrode 109 need not to be overlapped with each other in a plan view. In addition, the base substrate 101 and the lid substrate 102 are heated when bonded to each other via the bonding material 106. Then, there may be a case where wiring resistance of the lead-out electrodes 107a and 107b is increased. In this point of view, in a case where the size of the piezoelectric vibrator 100 is reduced, the size of the piezoelectric vibrating reed 103 or the width of the bonding material 106 cannot be reduced by a necessary amount or greater, and consequently, the electrode width of the lead-out electrode 107b is reduced and thus the resistance is increased, also resulting in deterioration of the vibration characteristics.

In order to solve the above problems, an object of the invention is to provide a piezoelectric vibrator capable of achieving a reduction in the size without deterioration of vibration characteristics.

A piezoelectric vibrator according to the invention includes: a base substrate; a piezoelectric vibrating reed which is held on a mounting portion formed on a surface of the base substrate in a cantilevered state; and a lid substrate which is installed on the base substrate and covers and accommodates the piezoelectric vibrating reed, wherein the piezoelectric vibrating reed has first and second excitation electrodes on outer surfaces thereof for driving, the base substrate has first and second through-electrodes which penetrate from the surface thereof to the rear surface on the reverse side, and a first lead-out electrode which is formed on the surface thereof and has one end connected to the first through-electrode and the other end connected to the mounting portion, the first lead-out electrode is formed in a peripheral region so as not to overlap with the first and second excitation electrodes as viewed in a direction normal to the surface of the base substrate, and the first excitation electrode is electrically connected to the first through-electrode via the mounting portion and the first lead-out electrode, and the second excitation electrode is electrically connected to the second through-electrode via the mounting portion.

In addition, preferably the lid substrate has a concave portion for accommodating the piezoelectric vibrating reed, an upper surface of a side wall of the concave portion is bonded to the base substrate, a conductor film is formed on a bonding surface where the lid substrate and the base substrate are bonded to each other, and the first lead-out electrode is electrically connected to the conductor film in the vicinity of the mounting portion and in the vicinity of the first through-electrode.

In addition, preferably the base substrate has a first connection portion positioned in the vicinity of the mounting portion and a second connection portion positioned in the vicinity of the first through-electrode, on the first lead-out electrode, and the lid substrate has a second lead-out electrode formed on the surface on a side where the piezoelectric vibrating reed is mounted, and the first and second lead-out electrodes are electrically connected to each other via the first and second connection portions.

An oscillator according to the invention includes: the piezoelectric vibrator according to any of the above descriptions; and a drive circuit for supplying a drive signal to the piezoelectric vibrator.

According to the invention, with regard to wires between the mounting portion and the first through-electrode, the first lead-out electrode formed on the base substrate is formed so as not to overlap with the first and second excitation electrodes along the outer peripheries of the first and second excitation electrodes as viewed in the direction normal to the base substrate, so that the resistance of the wires is reduced, thereby providing a small-sized piezoelectric vibrator which prevents degradation of vibration characteristics.

Embodiments of the present invention will now be described by way of further example only and with reference to the accompanying drawings, in which:
Figs. 1A and 1B are explanatory views of a piezoelectric vibrator according to an embodiment of the invention.
Figs. 2A and 2B are explanatory views of the piezoelectric vibrator according to the embodiment of the invention.
Figs. 3A and 3B are explanatory views of the piezoelectric vibrator according to the embodiment of the invention.
Figs. 4A and 4B are top views schematically illustrating a base substrate and a lid substrate of the piezoelectric vibrator according to the embodiment of the invention.
Figs. 5A and 5B are cross-sectional views schematically illustrating the piezoelectric vibrator according to the embodiment of the invention.
Fig. 6 is a top view schematically illustrating an oscillator according to the embodiment of the invention.
Figs. 7A to 7C are explanatory views of a well-known piezoelectric vibrator.

A piezoelectric vibrator according to the invention includes: a base substrate; a piezoelectric vibrating reed which is held on a mounting portion formed on a surface of the base substrate in a cantilevered state; and a lid substrate which covers and accommodates the piezoelectric vibrating reed and is bonded to a bonding portion on a peripheral portion of the base substrate. The piezoelectric vibrating reed has first and second excitation electrodes on its surface and the rear surface for causing excitation of the piezoelectric vibrating reed. The base substrate has first and second through-electrodes which penetrate from the surface thereof to the rear surface on the reverse side, and a first lead-out electrode which is formed on the surface thereof and has one end connected to the first through-electrode and the other end connected to the mounting portion. The first lead-out electrode is formed in a peripheral region so as not to overlap with the first and second excitation electrodes as viewed in a direction normal to the surface of the base substrate. Therefore, the first excitation electrode is electrically connected to the first through-electrode via the mounting portion, the first lead-out electrode, and the conductor film, and the second excitation electrode is electrically connected to the second through-electrode via the mounting portion.

When the outer shape of the piezoelectric vibrator is reduced, it becomes difficult to form the first and second through-electrodes to be close in one side of the base substrate. Here, the first and second through-electrodes may be formed at positions on the surface of the base substrate as far apart as possible. On the other hand, the piezoelectric vibrating reed needs to be installed on the mounting portion in the cantilevered state. Accordingly, the lead-out electrode is formed on the base substrate, and the lead-out electrode needs to be drawn from any one of or both of the first and second through-electrodes which are separated from each other so as to be connected to the mounting portion. According to the invention, the first lead-out electrode is formed in the peripheral region so as not to overlap with the first and second excitation electrodes as viewed in the direction normal to the surface of the base substrate. Accordingly, the resistance between the mounting portion and the first through-electrode can be reduced.

Moreover, the base substrate and the lid substrate may be made of a glass substrate. When the glass substrate is used, a molding process can be easily performed compared to a case where a ceramic substrate is used. In addition, since the glass material has a low thermal conductivity, an external temperature change is less likely to be transmitted to the piezoelectric vibrating reed, and a rapid temperature change is less likely to be influenced thereon. In addition, since the glass substrate is transparent, trimming of the first or second excitation electrode can be performed using laser light after a package is assembled. In addition, the base substrate and the lid substrate can be bonded by anodic bonding via the conductor film, so that airtightness of the package can be maintained for a long time. In addition, a conductive adhesive may be used instead of the anodic bonding.

A crystal substrate in an AT mode can be used for the piezoelectric vibrating reed. A conductive adhesive material or a metal bump can be used for the mounting portion. When the metal bump is used, the piezoelectric vibrating reed can be mounted within a short time, so that adhesion of the piezoelectric vibration in the cantilevered state can be easily performed. In addition, a conductive adhesive may be used for the first and second mounting portions instead of the metal bump. In addition, the first and second excitation electrodes can be formed to be opposite to each other with the piezoelectric vibrating reed interposed therebetween, and the first lead-out electrode is formed so as not to overlap with the first and second excitation electrodes as viewed in the direction normal to the surface of the base substrate. Accordingly, parasitic capacitance that occurs between the first lead-out electrode and the first and second excitation electrodes can be reduced, thereby stabilizing vibrations of the piezoelectric vibrating reed.

In addition, the concave portion for accommodating the piezoelectric vibrating reed in the lid substrate can be formed. The upper surface of the side wall of the concave portion is bonded to the peripheral portion of the base substrate. In this case, the conductor film may be formed on the bonding surface. The conductor film and the first lead-out electrode may be electrically connected to each other in the vicinity of the mounting portion and in the vicinity of the first through-electrode. Accordingly, the first lead-out electrode and the conductor film are connected in parallel between the mounting portion and the first through-electrode, thereby further reducing the resistance between the mounting portion and the first through-electrode.

In addition, the second lead-out electrode is formed on the surface of the lid substrate on the side where the piezoelectric vibrator is mounted, and the first connection portion and the second connection portion are formed on the surface of the base substrate respectively in the vicinity of the mounting portion and in the vicinity of the first through-electrode, so that the first and second connection portions are made to contact and electrically connect to the second lead-out electrode. Accordingly, the first lead-out electrode and the second lead-out electrode are connected in parallel between the mounting portion and the first through-electrode, thereby further reducing the resistance between the mounting portion and the first through-electrode. In addition, the second lead-out electrode may be formed in the peripheral region so as not to overlap with the first and second excitation electrodes as viewed in the direction normal to the surface of the base substrate. Accordingly, the resistance between the mounting portion and the first through-electrode can further be reduced. Hereinafter, detailed description will be provided with reference to the accompanying drawings.

### First Embodiment

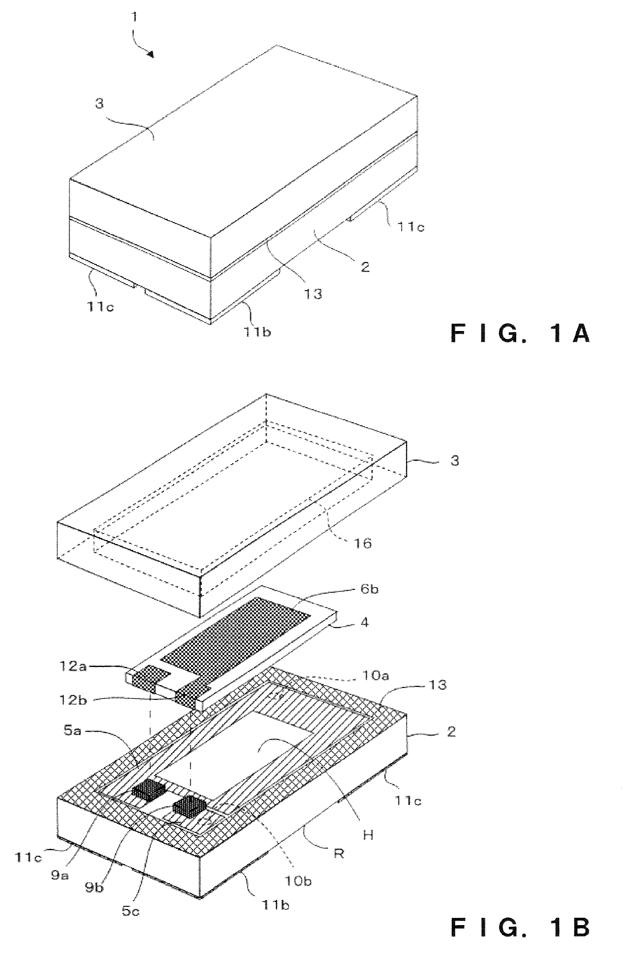

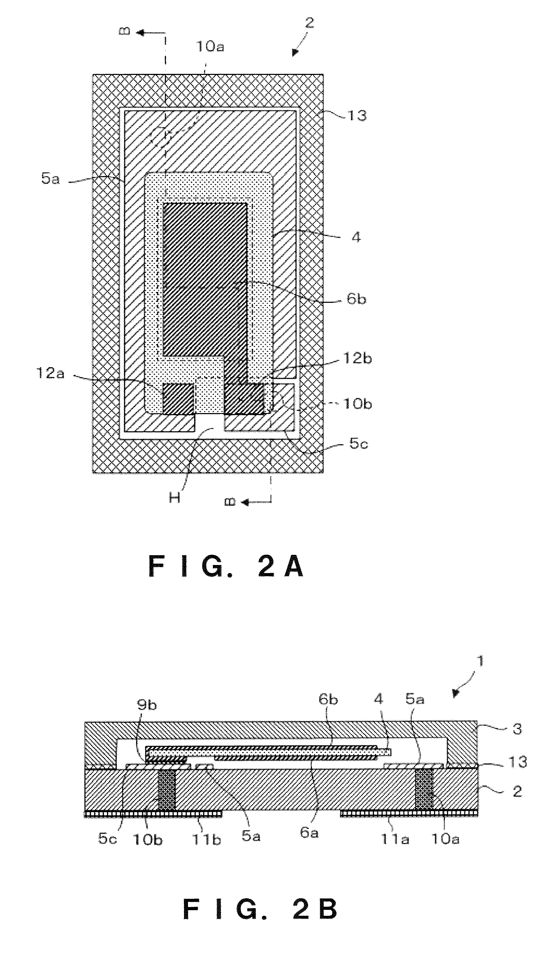

A piezoelectric vibrator 1 according to a first embodiment of the invention will be described with reference to Figs. 1A to 2B. Figs. 1A and 1B are explanatory views of the piezoelectric vibrator 1. Fig. 1A is a diagram of an outer appearance of the piezoelectric vibrator 1, and Fig. 1B is an exploded perspective view thereof. Figs. 2A and 2B are explanatory views of the piezoelectric vibrator 1. Fig. 2A is a top view schematically illustrating a base substrate 2, and Fig. 2B is a cross-sectional view schematically illustrating the piezoelectric vibrator 1 taken along the line B-B. Like elements which are the same or have the same functions are denoted by like reference numerals.

As illustrated in Figs. 1A and 1B, the piezoelectric vibrator 1 includes the base substrate 2, a piezoelectric vibrating reed 4 mounted on a surface of the base substrate 2, and a lid substrate 3 which is provided with a concave portion 16 so that an upper surface of a side wall of the concave portion 16 is bonded to a peripheral portion of the base substrate 2 via a bonding member 13. Here, a crystal plate that vibrates in an AT mode is used for the piezoelectric vibrating reed 4. A glass material is used for the base substrate 2 and the lid substrate 3. The base substrate 2 and the lid substrate 3 are bonded to each other by anodic bonding. A long side of the piezoelectric vibrator 1 having a rectangular shape has a length of equal to or smaller than several millimeters and a thickness of equal to or smaller than 0.1 mm.

The base substrate 2 has a rectangular shape. The base substrate 2 includes two through-electrodes 10a and 10b which penetrate from a surface H to a rear surface R in its diagonal region, and the bonding member 13 is provided on a peripheral portion of the surface H. The base substrate 2 includes first and third lead-out electrodes 5a and 5c on an inner peripheral side of the bonding member 13 in the vicinity of one short side of the surface H, and first and second mounting portions 9a and 9b formed on the first and third lead-out electrodes 5a and 5c. The base substrate 2 includes the first lead-out electrode 5a extending from the vicinity of the one short side on the inner peripheral side of the bonding member 13 to the vicinity of the other short side of the surface H. The bonding member 13 is formed of a conductor film such as aluminum or silicon.

The piezoelectric vibrating reed 4 is made of a rectangular thin plate and includes first and second excitation electrodes 6a and 6b (see Fig. 2B) for driving the piezoelectric vibrating reed 4 on both surfaces. The piezoelectric vibrating reed 4 further includes first and second terminal electrodes 12a and 12b from one surface in the vicinity of the one short side via a side surface of the short side over the other surface, and the first terminal electrode 12a is connected to the first excitation electrode 6a and the second terminal electrode 12b is connected to the second excitation electrode 6b. The piezoelectric vibrating reed 4 is mounted on the first and second mounting portions 9a and 9b in a cantilevered state. The base substrate 2 includes a first outer electrode 11 a formed at one corner portion of the other short side of the rear surface R, a second outer electrode 11 b formed at the diagonally opposite corner portion of the one short side of the rear surface R, and a dummy electrode 11c formed at another corner portion. The lid substrate 3 has the concave portion 16 on its surface on the base substrate 2 side and accommodates the piezoelectric vibrating reed 4. A bottom surface of the concave portion 16 is a flat surface.

Here, the first lead-out electrode 5a formed on the inner peripheral side of the bonding member 13 of the base substrate 2 is installed in a peripheral region so as not to overlap with the first and second excitation electrodes 6a and 6b as viewed in a direction normal to the surface H of the base substrate 2. As a result, a current flowing from the first mounting portion 9a to the first through-electrode 10a flows along two paths around the first and second excitation electrodes 6a and 6b, so that the resistance between the first mounting portion 9a and the first through-electrode 10a can be reduced. In addition, since the first lead-out electrode 5a does not overlap with the first and second excitation electrodes 6a and 6b, parasitic capacitance between the first lead-out electrode 5a and the first and second excitation electrodes 6a and 6b is reduced, thereby stabilizing vibration of the piezoelectric vibrator 4. It is noted, however, that the first lead-out electrode may, and in this embodiment does, overlap with part of the vibrating reed 4 where the first and second excitation electrodes 6a and 6b are not formed.

Detailed description will be provided with reference to Figs. 2A to 2C. The bonding member 13 made of a conductor film, for example, aluminum, silicon, or the like is provided on the outer peripheral portion of the base substrate 2. The second through-electrode 10b is provided in the corner region between the one short side (hereinafter, referred to as a lower side) and a right side on the inner peripheral side of the bonding member 13 formed on the outer peripheral portion of the base substrate 2, and the first through-electrode 10a is provided in a corner region between the other short side (hereinafter, referred to as an upper side) and a left side. A conductive adhesive material or metal may be used for the first and second through-electrodes 10a and 10b. When metal is used to weld its surface to the glass material, airtightness can be maintained for a long time.

The first and third lead-out electrodes 5a and 5c are electrically separated from each other on the inner peripheral side of the bonding member 13 and on the surface H of the base substrate 2. The first lead-out electrode 5a extends from a corner region between the lower side and the left side on the inner peripheral side of the bonding member 13 to the corner region between the upper side and the left side, covers the upper surface of the first through-electrode 10a, and is electrically connected to the first through-electrode 10a. The third lead-out electrode 5c covers the upper surface of the second through-electrode 10b in the corner region between the lower side and the right side on the inner peripheral side of the bonding member 13 and is electrically connected to the second through-electrode 10b.

The first and second mounting portions 9a and 9b (see Fig. 1 B) which are separated from each other are provided on the first and third lead-out electrodes 5a and 5c in the vicinity of the lower side, and the piezoelectric vibrating reed 4 is mounted thereon in the cantilevered state. A conductive adhesive material or a metal bump can be used for the first and second mounting portions 9a and 9b. When the metal bump is used, the metal bump solidifies within a short time when the piezoelectric vibrating reed 4 is pressure-bonded and barely expands in a horizontal direction, so that the first and second mounting portions 9a and 9b can be easily electrically separated from each other and thus the metal bump is very suitable for mounting the piezoelectric vibrating reed 4 in the cantilevered state. In addition, the concave portion 16 is formed on the surface of the lid substrate 3 on the piezoelectric vibrating reed 4 side, and the upper surface of the side wall of the concave portion 16 and the periphery of the base substrate 2 are bonded by anodic bonding via the bonding member 13. A metal film, for example, Au/Cr may be used for the first and third lead-out electrodes 5a and 5c.

The first mounting portion 9a is electrically connected to the first terminal electrode 12a formed on the lower side of the piezoelectric vibrating reed 4, and the second mounting portion 9b is electrically connected to the second terminal electrode 12b formed on the lower side of the piezoelectric vibrating reed 4. In addition, as viewed in the direction normal to the surface H of the base substrate 2, the first and second excitation electrodes 6a and 6b provided in the piezoelectric vibrating reed 4 are installed so as not to overlap with the first and third lead-out electrodes 5a and 5c.

As a result, the first excitation electrode 6a is electrically connected to the first outer electrode 11a via the first terminal electrode 12a, the first mounting portion 9a, the first lead-out electrode 5a, and the first through-electrode 10a, and the second excitation electrode 6b is electrically connected to the second outer electrode 11 b via the second terminal electrode 12b, the second mounting portion 9b, the third lead-out electrode 5c, and the second through-electrode 10b. Therefore, as a drive power is applied to the first and second outer electrodes 11a and 11 b to vibrate the piezoelectric vibrating reed 4, a frequency signal can be obtained by the first and second outer electrodes 11a and 11 b.

As such, since the first lead-out electrode 5a is formed in the peripheral region so as not to overlap with the first and second excitation electrodes 6a and 6b as viewed in the direction normal to the surface H of the base substrate 2, the resistance between the first mounting portion 9a and the first through-electrode 10a is reduced, and parasitic capacitance between the first lead-out electrode 5a and the first and second excitation electrodes 6a and 6b is reduced, thereby stabilizing vibration of the piezoelectric vibrator 4. Moreover, in the first embodiment, the concave portion is provided in the lid substrate 3. However, instead of this, the concave portion may be provided in the base substrate 2. In this case, the first lead-out electrode 5a and the first and second mounting portions 9a and 9b may be formed on the bottom surface of the concave portion.

In this embodiment, the first lead-out electrode 5a is effectively formed in a loop with the third lead-out electrode 5c disposed outside the loop. However, the third lead-out electrode 5c may also be disposed inside the loop.

### Second Embodiment

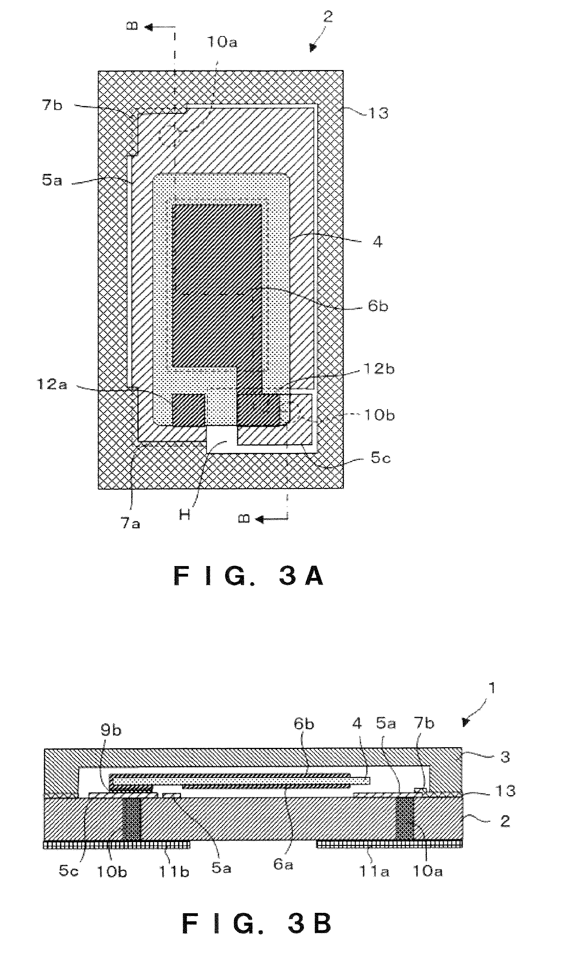

Figs. 3A and 3B are explanatory views of the piezoelectric vibrator 1 according to a second embodiment. Fig. 3A is a top view schematically illustrating the base substrate 2, and Fig. 3B is a cross-sectional view schematically illustrating the piezoelectric vibrator 1 taken along the line B-B. This embodiment is different from the first embodiment in that the conductor film formed at the bonding surface of the base substrate 2 and the lid substrate 3 is electrically connected to the first lead-out electrode 5a in the vicinity of the first mounting portion 9a and in the vicinity of the first through-electrode 10a. Other components are the same as those of the first embodiment. Therefore, hereinafter, the different components from those of the first embodiment will be mainly described. Like elements which are the same or have the same functions are denoted by like reference numerals.

As illustrated in Figs. 3A and 3B, the concave portion 16 is provided in the lid substrate 3 on the base substrate 2 side, and the upper surface of the side wall of the concave portion 16 is bonded to the outer peripheral portion of the base substrate 2. The bonding surface of the lid substrate 3 and the base substrate 2 forms the bonding member 13 made of the conductor film. In the case where the base substrate 2 and the lid substrate 3 are bonded by anodic bonding, 0.2 µm to 0.5 µm of, for example, aluminum or silicon is formed as the bonding member 13. In addition, instead of the anodic bonding, a conductive adhesive material may be used for the bonding member 13.

In this case, the bonding member 13 and the first lead-out electrode 5a are electrically connected to form a first connection portion 7a at a region in the vicinity of the first mounting portion 9a and a second connection portion 7b at a region in the vicinity of the first through-electrode 10a. The first and second connection portions 7a and 7b extend from the bonding member 13 so as to overlap with the first lead-out electrode 5a on the inner peripheral side. In addition, instead of extending the bonding member 13 toward the inner peripheral side, the first lead-out electrode 5a may extend toward the outer peripheral side to be electrically connected to the bonding member 13. Moreover, according to the second embodiment, the first and second connection portions 7a and 7b, that is, the two points are used for electrical connection. However, the invention is not limited thereto, and for example, excluding the region in the vicinity of the second connection portion 7b, the bonding member 13 and the first lead-out electrode 5a may be electrically connected along the entire region where they are close to each other.

As a result, the first excitation electrode 6a is electrically connected to the first outer electrode 11a via the first terminal electrode 12a, the first mounting portion 9a, the first lead-out electrode 5a, the bonding member 13, and the first through-electrode 10a. In addition, the second excitation electrode 6b is electrically connected to the second outer electrode 11 b via the second terminal electrode 12b, the third lead-out electrode 5c, and the second mounting portion 9b. Accordingly, the first lead-out electrode 5a and the bonding member 13 are connected in parallel between the first mounting portion 9a and the first through-electrode 10a, so that the resistance between the first mounting portion 9a and the first through-electrode 10a can be reduced.

### Third Embodiment

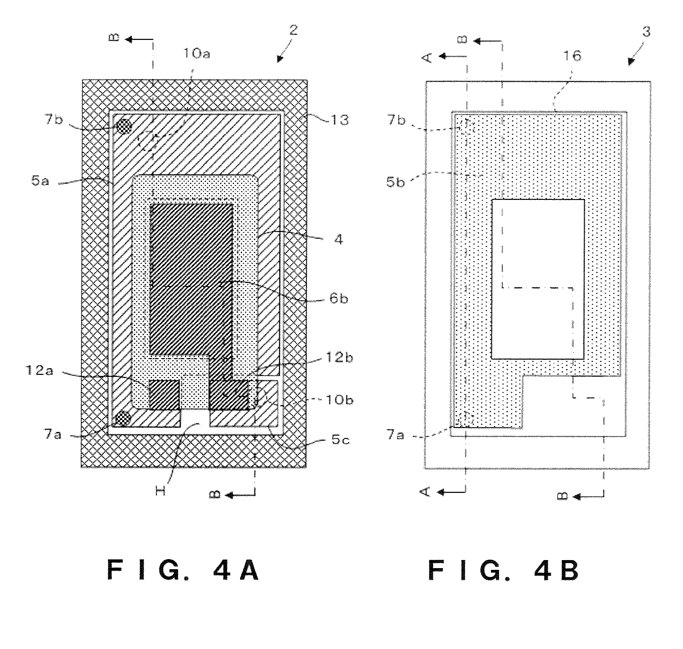

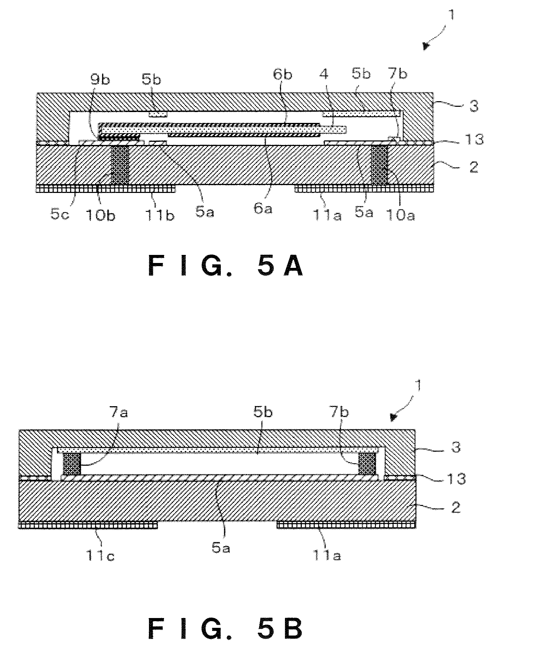

Figs. 4A to 5B are explanatory views of the piezoelectric vibrator 1 according to a third embodiment of the invention. Fig. 4A is a top view schematically illustrating the base substrate 2, Fig. 4B is a top view schematically illustrating the lid substrate 3, Fig. 5A is a cross-sectional view schematically illustrating the piezoelectric vibrator 1 taken along the line B-B, and Fig. 5B is a cross-sectional view schematically illustrating the piezoelectric vibrator 1 taken along the line A-A. This embodiment is different from the first embodiment in that a second lead-out electrode 5b is formed on the surface of the lid substrate 3 on the base substrate 2 side so that the first lead-out electrode 5a and the second lead-out electrode 5b are electrically connected via the first connection portion 7a formed in the region in the vicinity of the second mounting portion 9b and via the second connection portion 7b formed in the region in the vicinity of the first through-electrode 10a. Other components are the same as those of the first embodiment, so that detailed description will be omitted. Like elements which are the same or have the same functions are denoted by like reference numerals.

As illustrated in Figs. 4A and 4B, the surface H of the base substrate 2 has the first and third lead-out electrodes 5a and 5c, the first mounting portion 9a formed on the first lead-out electrode 5a, the second mounting portion 9b formed on the third lead-out electrode 5c, and the piezoelectric vibrating reed 4 mounted on the first and second mounting portions 9a and 9b in the cantilevered state. Furthermore, the base substrate 2 has, on the first lead-out electrode 5a, the first connection portion 7a formed in the region in the vicinity of the first mounting portion 9a and the second connection portion 7b formed in the region in the vicinity of the first through-electrode 10a.

The lid substrate 3 has the concave portion 16 on the surface on the base substrate 2 side, and the second lead-out electrode 5b is formed on the bottom surface of the concave portion 16. The second lead-out electrode 5b has substantially the same shape as the first lead-out electrode 5a as viewed in the direction normal to the surface of the base substrate 2. That is, the second lead-out electrode 5b is formed in the outer peripheral region so as not to overlap with the first and second excitation electrodes 6a and 6b, and the first and second lead-out electrodes 5a and 5b are electrically connected to each other via the first and second connection portions 7a and 7b. As a result, between the first mounting portion 9a and the first through-electrode 10a, the first and second lead-out electrodes 5a and 5b are connected in parallel, and furthermore, the first and second lead-out electrodes 5a and 5b are formed in the peripheral region so as not to overlap with the first and second excitation electrodes 6a and 6b, thereby further reducing the resistance of the lead-out electrodes.

Moreover, instead of forming the second lead-out electrode 5b in the peripheral region of the first and second excitation electrodes 6a and 6b, the second lead-out electrode 5b may also be formed only on the outer peripheral side of the left side. In addition, in the case where the bonding member 13 is a conductor, as in the second embodiment, the bonding member 13 may be configured to be electrically connected to the first lead-out electrode 5a or the second lead-out electrode 5b via at least the first and second connection portions 7a and 7b. Accordingly, between the first mounting portion 9a and the first through-electrode 10a, the first lead-out electrode 5a, the second lead-out electrode 5b, and the bonding member 13 are connected in parallel, thereby further reducing the resistance of the lead-out electrodes.

### Fourth Embodiment

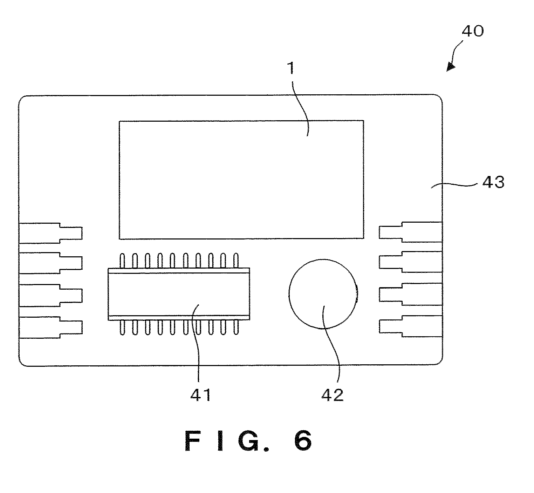

Fig. 6 is a top view schematically illustrating an oscillator 40 according to a fourth embodiment of the invention. As illustrated in Fig. 6, the oscillator 40 includes a substrate 43, the piezoelectric vibrator 1 installed on the substrate according to any one of the first to third embodiments, an integrated circuit 41, and an electronic component 42. The piezoelectric vibrator 1 generates a signal with a predetermined frequency on the basis of a drive signal that may be transmitted to the outer electrodes 11a and 11 b, and the integrated circuit 41 and the electronic component 42 process the signal with the predetermined frequency supplied from the piezoelectric vibrator 1 and generate a reference signal such as a clock signal. The piezoelectric vibrator 1 according to the invention can be formed with high reliability and to have a small size, thereby achieving a compact size for the oscillator 40.

The foregoing description has been given by way of example only and it will be appreciated by a person skilled in the art that modifications can be made without departing from the scope of the present invention.

For example, a rectangular shape is not required for any/all of the components, and the corners need not be right-angled. Moreover, the expression "corner" should be interpreted in a broad sense to encompass any angular region.

In addition, in the embodiments the concave portion is provided in the lid substrate 3. However, instead of this the concave portion may be provided in the base substrate 2. In this case, the first lead-out electrode 5a and the first and second mounting portions 9a and 9b may be formed on a bottom surface of the concave portion, and the first and second connection portions 7a and 7b may be formed on the bottom surface of the concave portion from an upper surface of the concave portion via its inner side surface.

Furthermore, in the embodiments the first and second through-electrodes 10a and 10b are installed in diagonally opposite regions of the rectangular base substrate 2. However, the invention is not limited to this, and the first and second through-electrodes 10a and 10b may be installed on the opposite sides to each other or on one of the sides.

## Claims

1. A piezoelectric vibrator (1) comprising:
a base substrate (2);
a piezoelectric vibrating reed (4) which is held on a mounting portion (9a, 9b) formed on a surface (H) of the base substrate in a cantilevered state; and
a lid substrate (3) which is installed on the base substrate and covers the piezoelectric vibrating reed,
wherein the piezoelectric vibrating reed has first and second excitation electrodes (6a, 6b) on outer surfaces thereof for driving,
the base substrate has first and second through-electrodes (10a, 10b) which penetrate from the surface thereof to the rear surface on the reverse side, and a first lead-out electrode (5a) which is formed on the surface thereof and has one end connected to the first through-electrode and the other end connected to the mounting portion,
the first lead-out electrode is formed in a peripheral region so as not to overlap with the first and second excitation electrodes as viewed in a direction normal to the surface of the base substrate, and
the first excitation electrode is electrically connected to the first through-electrode via the mounting portion and the first lead-out electrode, and the second excitation electrode is electrically connected to the second through-electrode via the mounting portion.

2. The piezoelectric vibrator according to claim 1,
wherein the lid substrate has a concave portion (16) for accommodating the piezoelectric vibrating reed,
an upper surface of a side wall of the concave portion is bonded to the base substrate,
a conductor film (13) is formed on a bonding surface where the lid substrate and the base substrate are bonded to each other, and
the first lead-out electrode is electrically connected to the conductor film in the vicinity of the mounting portion and in the vicinity of the first through-electrode.

3. The piezoelectric vibrator according to claim 1 or 2,
wherein the base substrate has a first connection portion (7a) positioned in the vicinity of the mounting portion and a second connection portion (7b) positioned in the vicinity of the first through-electrode, and
the lid substrate has a second lead-out electrode (5b) formed on the surface on a side where the piezoelectric vibrating reed is mounted, and the first and second lead-out electrodes are electrically connected to each other via the first and second connection portions.

4. An oscillator comprising:
the piezoelectric vibrator according to any one of claims 1 to 3; and
a drive circuit (41) for supplying a drive signal to the piezoelectric vibrator.
